# EUROPÄISCHE PATENTSCHRIFT

(11) **EP 4 078 195 B1**
(45) Veröffentlichungstag und Bekanntmachung des Hinweises auf die Patenterteilung: **09.10.2024**
(21) Anmeldenummer: 20837989.1
(22) Anmeldetag: 17.12.2020
(51) Int. Cl.: G01R 1/067, G01R 1/073

(54) **KONTAKTSTIFT MIT INDIVIDUELL BEWEGLICHEN KONTAKTELEMENTEN**
CONTACT PIN WITH INDIVIDUALLY MOVABLE CONTACT ELEMENTS
BROCHE DE CONTACT AYANT DES ÉLÉMENTS DE CONTACT INDIVIDUELLEMENT MOBILES

(30) Priorität: 19.12.2019 DE 102019220311
(43) Veröffentlichungstag der Anmeldung: 26.10.2022
(73) Patentinhaber: Feinmetall GmbH, 71083 Herrenberg (DE)
(72) Erfinder: BENEDIX, Lutz, 71083 Herrenberg (DE); BURGOLD, Jörg, 71083 Herrenberg (DE)
(74) Vertreter: Clarenbach, Carl-Philipp
(86) Internationale Anmeldenummer: PCT/EP2020/086909
(87) Internationale Veröffentlichungsnummer: WO 2021/123081

(56) Entgegenhaltungen:
- EP-A1- 3 156 805
- WO-A1-2019/022391
- KR-A- 20180 067 229
- KR-B1- 101 451 319
- US-A1- 2017 248 659

## Beschreibung

Die Erfindung betrifft eine Kontakteinrichtung zur Berührungskontaktierung einer elektrischen Kontaktstelle eines Prüflings, mit einem Kontaktkolben, der einen Kolbenschaft zur axial verschiebbaren Lagerung in einer Führungshülse sowie an einem freien Ende des Kolbenschafts einen dem Prüfling zuordenbaren Kontaktkopf aufweist, und mit zumindest einem an und/oder in dem Kontaktkopf bewegbar gelagerten Kontaktelement, wobei dem Kontaktelement zumindest ein Federelement zugeordnet ist, das durch das Kontaktelement bei einer Belastung durch eine Berührungskontaktierung entgegen seiner Federkraft elastisch verformbar ist.

Kontakteinrichtungen der eingangs genannten Art sind aus dem Stand der Technik bekannt. Zur Berührungskontaktierung von Prüflingen werden häufig Federkontaktstifte eingesetzt, die eine Führungshülse und ein in der Führungshülse verschiebbar gelagertes, kolbenförmiges Kontaktelement aufweisen. In der Führungshülse ist außerdem ein Federelement angeordnet, welches das Kontaktelement aus der Führungshülse heraus drängt, sodass bei einer Berührungskontaktierung das Kontaktelement entgegen der Kraft des Federelements in die Führungshülse hineingeschoben werden kann. Die axiale Verschiebbarkeit des Kontaktelements hat den Vorteil, dass bei der Verwendung einer Vielzahl derartiger Kontakteinrichtungen in einem Kontaktkopf einer Prüfeinrichtung sichergestellt ist, dass alle Kontaktstellen zur Prüfung des Prüflings berührungskontaktiert werden. Durch die Berührungskontaktierung wird eine elektrische Verbindung zu dem Prüfling hergestellt, mittels welcher der Prüfling elektrisch auf seine Funktionsfähigkeit getestet werden kann. Dazu wird beispielsweise der Prüfling an einer der Kontaktstellen durch eine Kontakteinrichtung mit einer elektrischen Spannung und/oder einem elektrischen Strom beaufschlagt, und an einer anderen der Kontaktstellen des Prüflings wird die Reaktion des Prüflings auf die Beaufschlagung elektrisch überwacht.

Aus der Offenlegungsschrift KR 101 451 319 B1 ist eine gattungsgemäße Kontakteinrichtung bekannt. Weitere Kontakteinrichtungen sind aus den Offenlegungsschriften WO 2019/022391 A1, US 2017/248659 A1, EP 3 156 805 A1 und KR 2018 0067229 A bekannt.

Der Erfindung liegt die Aufgabe zugrunde, eine verbesserte Kontakteinrichtung zu schaffen, die ein sicheres Berührungskontaktieren auch von großflächigen Kontaktstellen erlaubt, selbst wenn diese uneben ausgebildet sind.

Die der Erfindung zugrundeliegende Aufgabe wird durch eine Kontakteinrichtung mit den Merkmalen des Anspruchs 1 gelöst. Diese hat den Vorteil, dass sich der Kontaktkopf vorteilhaft an die Kontaktstelle des Prüflings anpasst, wobei die Kontakteinrichtung mit technisch einfachen Mitteln und damit kostengünstig herstellbar ist. Die Erfindung zeichnet sich dadurch aus, dass an dem Kontaktkopf mehrere der Kontaktelemente, die jeweils eine Kontaktfläche zur Berührungskontaktierung aufweisen, derart nebeneinander angeordnet sind, dass die Kontaktflächen im unbelasteten Zustand zusammen eine zumindest im Wesentlichen durchgehende Kontaktoberfläche des Kontaktkopfs für die Kontaktstelle ausbilden. Der Kontaktkopf weist somit eine Vielzahl von Kontaktelementen auf, die im unbelasteten Zustand eine geschlossene oder nahezu geschlossene Kontaktoberfläche bilden. Dazu weist jedes Kontaktelement eine Kontaktfläche auf, die dem Prüfling zugewandt beziehungsweise von dem Kontaktkopf abgewandt ist, wobei die Kontaktflächen sich insbesondere in einer Ebene erstrecken, und dass jede Kontaktfläche für sich eine zumindest im Wesentlichen ebene Auflagefläche für den Prüfling sowie die Kontaktstelle des Prüflings bietet. Im unbelasteten Zustand der Kontaktelemente liegen diese Kontaktflächen in einer gemeinsamen Ebene, sodass die Kontaktoberfläche des Kontaktkopfs ausgebildet wird. Wird nunmehr die Kontakteinrichtung mit dem Kontaktkopf dem Prüfling zugeführt, sodass die Kontaktelemente auf eine Kontaktstelle treffen, so federn die Kontaktelemente unabhängig voneinander entgegen der Kraft des jeweils zugeordneten Federelements ein, sodass sich die Kontaktoberfläche des Kontaktkopfs insgesamt an die Oberfläche der Kontaktstelle anpasst. Wie bereits erwähnt, ist dadurch eine sichere und auch großflächige Kontaktierung der Kontaktstelle, selbst bei einer unebenen Ausbildung der Kontaktstelle, gewährleistet.

Gemäß einer bevorzugten Weiterbildung der Erfindung bilden zumindest einige der Kontaktelemente zur Ausbildung einer ringförmigen Kontaktoberfläche jeweils eine Ringsegmentfläche mit ihrer Kontaktfläche aus. Die Kontaktflächen der Kontaktelemente sind somit derart gestaltet, dass zumindest einige der Kontaktflächen Ringsegmentflächen ausbilden. Dadurch ergibt sich, dass zumindest einige der Kontaktelemente ringförmig an dem Kontaktkopf angeordnet sind. Durch die Ringform ergibt sich eine vorteilhafte Kontaktierung der Kontaktstelle des Prüflings.

Vorzugsweise weist die Kontaktoberfläche eine kreisförmige, oval- oder mehreckige Kontur, insbesondere Außenkontur auf. Die Kontaktoberfläche ist somit nicht auf eine kreisförmige Ausbildung beschränkt, sondern kann auch oval oder mehreckig ausgebildet sein. Auch eine Mischung von einer Kreisform, Ovalform und Mehreckform ist denkbar. Dabei ist die Kontaktoberfläche zweckmäßigerweise an die zu prüfende Kontaktstelle eines Prüflings in ihrer Außenkontur oder Form angepasst. In jedem Fall ist eine ringförmige Ausbildung der Kontaktoberfläche möglich, wobei auch eine scheibenförmige Ausbildung der Kontaktoberfläche gemäß einer weiteren Ausführungsform bevorzugt ist, sodass sich eine insgesamt geschlossene Oberfläche ergibt.

Besonders bevorzugt bilden die Kontaktflächen der Kontaktelemente Kreissegmentflächen der Kontaktoberfläche. Dadurch sind die Kontaktflächen jeweils keilförmig ausgebildet und weisen mit ihren spitzen Enden auf ein Zentrum des Kontaktkopfs beziehungsweise der Kontaktoberfläche. Dadurch ist eine vorteilhafte Aufteilung der Kontaktoberfläche in einzelne Segmente gewährleistet.

Weiterhin ist bevorzugt vorgesehen, dass jedes Kontaktelement nur durch das jeweils zugeordnete Federelement an dem Kontaktkopf gehalten ist. Dadurch kann auf weitere Führungsmittel verzichtet werden. Das Federelement bildet somit zum einen das Halte- und Führungselement für das Kontaktelement aus, und bietet zum anderen die oben beschriebene Federkraft, die ein Verlagern des Kontaktelements bei Berührungskontaktierung erlaubt. Insbesondere ist das Federelement derart ausgebildet, dass das Kontaktelement axial beziehungsweise in Längserstreckung des Kontaktkolbens einfedern kann. Gemäß einer ersten Ausführungsform ist das Federelement derart ausgebildet, dass das Kontaktelement nur axial einfedern kann. Gemäß einer weiteren Ausführungsform ist das Federelement dazu ausgebildet, dass das Kontaktelement axial einfedern und zusätzlich verkippen oder verschwenken kann. Dadurch wird eine besonders vorteilhafte Anpassung der Kontaktoberfläche des Kontaktkopfes an die Kontaktstelle des Prüflings erreicht.

Vorzugsweise ist das jeweilige Kontaktelement als Ringsegmentabschnitt in einer Ebene quer, insbesondere senkrecht zur Längserstreckung des Kolbens beabstandet zu dem Kontaktkopf angeordnet. Dadurch weist das jeweilige Kontaktelement einen axialen Abstand zu dem Kontaktkopf auf, sodass ein Einfedern in Richtung des Kontaktkopfs gewährleistet ist. Insbesondere ist das jeweilige Ringsegment als flaches Ringsegment ausgebildet, sodass sich bei geringer Bauhöhe ein großer Federweg ergibt.

Weiterhin ist erfindungsgemäß vorgesehen, dass das jeweilige Federelement einendig an dem Kontaktelement und anderendig an dem Kontaktkopf befestigt ist und zumindest abschnittsweise schräg in Bezug auf die Längserstreckung des Kolbens verlaufend ausgebildet ist. Durch den schrägen Verlauf wird erreicht, dass das Federelement durch ein elastisches Verbiegen die gewünschte Verlagerung des jeweiligen Kontaktelements erlaubt. Insbesondere ist das Federelement derart ausgebildet, dass eine zumindest im Wesentlichen axiale Verlagerung, also eine Verlagerung in Längserstreckung des Kolbens, gewährleistet ist, bei welcher das Kontaktelement selbst seine Ausrichtung quer zur Längserstreckung des Kolbens zumindest im Wesentlichen beibehält.

Besonders bevorzugt weist das Federelement einen gekrümmten Verlauf von dem Kontaktkopf zu dem Kontaktabschnitt auf, sodass durch die Krümmung der Verlauf quer oder schräg zur Längserstreckung des Kolbens gebildet ist. Durch den gekrümmten Verlauf wird die Federsteifigkeit des Federelements weiter beeinflusst, beispielsweise reduziert. Alternativ verläuft das Federelement insgesamt entlang einer Geraden von dem Kontaktkopf bis zu dem Kontaktelement, wodurch ebenfalls eine elastische Verformbarkeit gewährleistet ist.

Besonders bevorzugt ist der Federabschnitt S-förmig verlaufend ausgebildet, um eine vorteilhafte Elastizität zu bieten, die auch ein Verschwenken oder Verkippen des jeweiligen Kontaktelements beim Einfedern erlaubt, sodass die weiter verbesserte Anpassung der Kontaktoberfläche insgesamt an die Kontaktstelle des Prüflings ermöglicht ist.

Gemäß einer bevorzugten Weiterbildung der Erfindung ist das Federelement an einem Außenrand des Kontaktelements mit dem Kontaktelement verbunden. Das hat zur Folge, dass insbesondere der weiter innenliegende Abschnitt des Kontaktelements besonders leicht in Richtung des Kolbens verlagerbar ist, sodass eine vorteilhafte Anpassung der Kontaktoberfläche insgesamt, insbesondere auch ein Umfassen einer von dem Prüfling vorstehenden Kontaktstelle von mehreren Seiten ermöglicht ist.

Vorteilhafterweise ist das Federelement derart ausgebildet, dass es ausgehend von dem Außenrand des Kontaktelements zu dem Kontaktkopf in Richtung des Innenrands des Kontaktelements verlaufend ausgerichtet ist. Dadurch liegt das dem Kontaktkopf zugeordnete Ende des Federelements weiter im Inneren des Kontaktkopfs als das dem Kontaktelement zugeordnete Ende, wodurch sich ein vorteilhafter Federweg sowie eine vorteilhafte Verlagerung des Kontaktelements und damit eine vorteilhafte Anpassung der Kontaktoberfläche ergibt.

Besonders bevorzugt ist das Federelement einstückig mit dem Kontaktelement und/oder mit dem Kontaktkopf ausgebildet. Dadurch ergibt sich eine integrale Ausbildung insbesondere auch des Kontaktelements mit dem Kontaktkopf. Bei einer insgesamt einstückigen Ausbildung von Kontaktelement, Federelement und Kontaktkopf ist eine vorteilhafte Fertigbarkeit mit gängigen 3D-Metalldruckverfahren gewährleistet.

Weiterhin ist bevorzugt vorgesehen, dass die freien, nach innen weisenden Enden der Kontaktelemente zur Ausbildung einer Durchgangsöffnung beabstandet zueinander enden. Zum einen wird hierdurch die Ringform der Kontaktoberfläche definiert, durch welche ein miteinander Verhaken oder Verklemmen einander gegenüberliegender Kontaktelemente bei Berührungskontaktierung verhindert wird, und zum anderen wird dadurch ermöglicht, dass im Bereich der Durchgangsöffnung zumindest ein weiterer Sensor oder zumindest ein weiteres Kontaktelement angeordnet werden kann, das zur Durchführung eines Tests an dem Prüfling von Vorteil ist. Auch erlaubt der Abstand der Kontaktelemente zueinander an ihren aufeinander zuweisenden Enden, dass die Kontaktelemente ohne zu verkanten oder zu verklemmen unter elastischer Verformung des Federelements verlagert werden können.

Vorzugsweise ist der jeweilige Federabschnitt zumindest abschnittsweise in seiner Längserstreckung lamelliert ausgebildet. Dadurch wird die Elastizität des jeweiligen Federelements erhöht und Gewicht gespart. Insbesondere verlaufen die Lamellen parallel zueinander und sind durch jeweils einen Längsschlitz in dem Federelement voneinander getrennt. Das Federelement ist dazu insbesondere streifenförmig ausgebildet.

Weiterhin weist der Kontaktkopf bevorzugt ein parallel und beabstandet zu dem jeweiligen Federelement verlaufendes Stützelement zur Begrenzung eines Bewegungswegs eines zugeordneten Kontaktelements auf. Das jeweilige Kontaktelement kann somit nur maximal bis zu dem Stützelement elastisch verlagert werden. Dadurch wird zum einen eine Überanspruchung des jeweiligen Federelements vermieden, und zum anderen eine vorteilhafte Führung und Ausrichtung des jeweiligen Kontaktkopfs gewährleistet. Vorzugsweise ist das jeweilige Stützelement ebenfalls elektrisch leitfähig ausgebildet, sodass es als zusätzlicher Strompfad dient, sobald das jeweilige Federelement und/oder Kontaktelement an dem Stützelement anliegt.

Besonders bevorzugt ist das jeweilige Stützelement aus dem gleichen Material gefertigt, wie Kontaktelement und/oder Federelement. Im Extremfall kann durch das jeweilige Stützelement der einzige Strompfad von dem Prüfling zu der Testeinrichtung gebildet werden, wodurch der Kontaktkopf wie bei einem klassischen Federkontaktstiftstab beziehungsweise plastisch adaptiv arbeiten würde. Die Stützelemente weisen insbesondere jeweils eine eigene Biegebegrenzungsstruktur auf und wirken vorzugsweise als thermische Masse- und Wärmeableiter. Gemäß einer bevorzugten Ausführungsform sind Kontaktelement, Federelement und zugehöriges Stützelement derart ausgebildet, dass das Kontaktelement derart weit einfedern kann, dass das Stützelement in direkte Anlage mit dem Prüfling gelangt, wodurch ein Strom-Bypass durch das jeweilige Stützelement hergestellt wird.

Vorzugsweise weist der Kontaktkopf eine wannenförmige, insbesondere V-förmige Aufnahme auf, in welcher die Federelemente und optional auch die Kontaktelemente angeordnet sind. Durch die wannenförmige Aufnahme wird insbesondere durch die Seitenwand der Aufnahme das Stützelement für die Federelemente beziehungsweise Kontaktelemente gebildet. Insbesondere ist die Seitenwand der Aufnahme in Umfangsrichtung gesehen durchgehend ausgebildet, sodass ein gemeinsames Stützelement für alle Federelemente und/oder Kontaktelemente auf einfache Art und Weise gegeben ist. Darüber hinaus wird durch die Anordnung der Federelemente innerhalb der Aufnahme gewährleistet, dass diese vor äußeren Einflüssen, und insbesondere vor Beschädigungen durch unerwartete Krafteinwirkungen geschützt sind.

Weiterhin ist bevorzugt vorgesehen, dass die Kontaktflächen der Kontaktelemente jeweils eine Kontaktspitzen aufweisende Oberflächenstruktur aufweisen. Durch die Kontaktspitzen an der jeweiligen Kontaktfläche wird eine vorteilhafte elektrische Berührungskontaktierung des Prüflings beziehungsweise der jeweiligen Kontaktstelle des Prüflings gewährleistet. Insbesondere führen die Kontaktspitzen zusammen mit der Verlagerung des jeweiligen Kontaktelements durch das Federelement dazu, dass die Kontaktspitzen die Kontaktstelle des Prüflings bei der Verlagerung des Kontaktelements ankratzen. Insbesondere sind die Kontaktelemente nicht nur axial verlagerbar, sondern werden durch die vorteilhafte Ausbildung des Federelements auch quer beziehungsweise radial beim Einfedern verschoben, wie zuvor bereits erwähnt. Dadurch kratzen die Kontaktspitzen an der Oberfläche der Kontaktstelle, wodurch beispielsweise eine Korrosionsschutzschicht der Kontaktstelle durchdrungen und eine sichere elektrische Verbindung zu dem Prüfling hergestellt wird. Besonders bevorzugt ist die jeweilige Oberflächenstruktur als Pyramidenstruktur ausgebildet, die jeweils eine Vielzahl von Kontaktspitzen aufweist. Vorzugsweise sind die Kontaktspitzen derart hart und spitz ausgebildet, dass sie den Gegenkontakt beziehungsweise die Kontaktstelle des Prüflings oberflächlich ankratzen können.

Weiterhin ist bevorzugt vorgesehen, dass an dem Kontaktkopf zumindest ein Sensorstift oder Kontaktstift derart angeordnet ist, dass ein freies Ende des Sensorstifts oder Kontaktstifts der Durchgangsöffnung zugeordnet ist. Hierdurch sind zusätzliche Sensiermittel und/oder Kontaktmittel vorhanden, welche die Funktionalität der Kontakteinrichtung und einer die Kontakteinrichtung aufweisenden Prüfeinrichtung erweitert. Insbesondere weisen die zusätzlichen Sensiermittel zumindest einen Temperatursensor auf, zum Erfassen einer Temperatur des Kontaktkopfs und/oder des Prüflings.

Besonders bevorzugt weist der Kontaktkopf außerdem zumindest einen Kühlmittelkanal auf. Durch den Kühlmittelkanal ist vorzugsweise ein Kühlmittel, insbesondere ein flüssiges oder gasförmiges Kühlmedium förderbar, durch welches Wärme aus dem Kontaktkopf abtransportiert beziehungsweise abgeführt werden kann. Weil im Prüfbetrieb zum Teil auch höhe Ströme durch den Kontaktkopf oder zumindest durch die Kontaktelemente des Kontaktkopfs fließen, wird durch die vorteilhafte Kühlmöglichkeit erreicht, dass ein Überhitzen des Kontaktkopfs und/oder der Kontaktelemente im Betrieb sicher verhindert wird.

Vorzugsweise ist der Kühlmittelkanal durch den Stützabschnitt beziehungsweise die Stützabschnitte zu den Kontaktelementen geführt. Dadurch liegt der Kühlmittelkanal nahe zu den Kontaktelementen und Wärme wird beispielsweise von den Kontaktelementen in den jeweiligen Stützabschnitt und von da aus in den Kühlmittelkanal und das dadurch geförderte Kühlmedium transportiert. Auch hierbei ist die vorteilhafte Ausrichtung der Stützabschnitte parallel zu den Federelementen und/oder Kontaktelementen im unbelasteten Zustand von Vorteil, weil dadurch eine großflächige Wärmeübertragung in das Kühlmedium gewährleistet ist.

Besonders bevorzugt weist der Kühlmittelkanal für jedes Kontaktelement zumindest eine dem jeweiligen Kontaktelement zugeordnete Durchströmungsöffnung auf. Dies ist insbesondere dann von Vorteil, wenn durch den Kühlmittelkanal ein gasförmiges Kühlmedium gefördert wird, das dann die Kontaktelemente und/oder Federelemente direkt beaufschlagt, um eine vorteilhafte Wärmeabfuhr zu gewährleisten. Besonders bevorzugt ist die jeweilige Durchströmungsöffnung derart ausgebildet, dass das ausströmende Kühlmedium in Richtung des Prüflings abströmt, sodass es auch an dem Prüfling eine Kühlwirkung erzielt.

Alternativ oder zusätzlich ist der Kontaktkopf insgesamt, zumindest aber der Kühlmittelkanal, das Stützelement oder die Stützelemente aus einem porösen Material gefertigt, zumindest im Bereich eines Federelements und/oder Kontaktelements, durch welches ein gasförmiges Medium aus dem Kühlmittelkanal in Richtung der Kontaktelemente und/oder Federelemente strömen kann. Dadurch kann auf konkrete Durchströmungsöffnungen verzichtet werden, was die Herstellung der Kontakteinrichtung insgesamt vereinfacht. Eine ausreichende Kühlung der Kontaktelemente beziehungsweise des Kontaktkopfs insgesamt wird dadurch dennoch erreicht.

Weiterhin ist bevorzugt vorgesehen, dass der Kolbenschaft in einer Führungshülse geführt ist, wobei zwischen der Stifthülse und dem Kontaktkopf ein weiteres Federelement axial vorspannbar oder vorgespannt angeordnet ist. Dadurch ist erreicht, dass der Kolben beziehungsweise der Kontaktkopf relativ zu der Führungshülse insgesamt axial verlagerbar ist, um insbesondere bei einem Anwendungsfall, in welchem eine Vielzahl derartiger Kontakteinrichtungen in einem Prüfkopf angeordnet sind, zu gewährleisten, da sämtliche Kontaktstellen sicher elektrisch kontaktiert werden.

Der erfindungsgemäße Prüfkopf mit den Merkmalen des Anspruchs 24 zeichnet sich dadurch aus, dass er eine Vielzahl der erfindungsgemäß ausgebildeten Kontakteinrichtungen trägt. Es ergeben sich dadurch die bereits genannten Vorteile.

Im Folgenden soll die Erfindung anhand der Zeichnungen näher erläutert werden. Dazu zeigen
- Figur 1: eine vorteilhafte Kontakteinrichtung in einer perspektivischen Darstellung,
- Figur 2: die Kontakteinrichtung aus Figur 1 in einer Längsschnittdarstellung,
- Figuren 3A und 3B: eine Detailschnittdarstellung der Kontakteinrichtung,
- Figur 4: eine Draufsicht auf einen Kontaktkopf der Kontakteinrichtung im belasteten Zustand,
- Figur 5: eine vergrößerte Längsschnittdarstellung der Kontakteinrichtung mit einer vorteilhaften Kühleinrichtung und
- Figur 6: eine Längsschnittdarstellung der Kontakteinrichtung mit einer Variante der Kühleinrichtung.

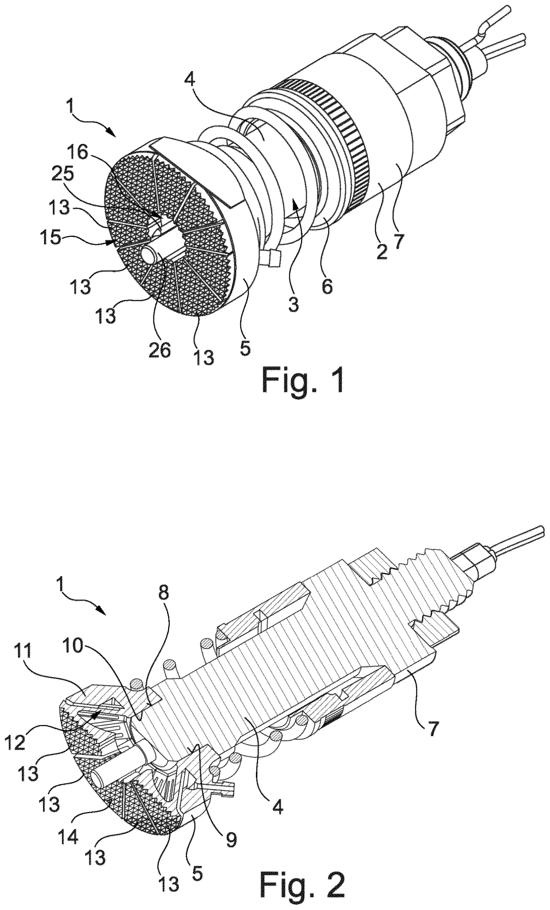

Figur 1 zeigt in einer vereinfachten perspektivischen Darstellung eine vorteilhafte Kontakteinrichtung 1, die an einem Prüfkopf zur Durchführung eines Tests an einem elektrischen/elektronischen Prüfling anordenbar ist. Die Kontakteinrichtung 1 weist eine Führungshülse 2 auf, welche an dem Prüfkopf befestigbar ist. In der Führungshülse 2 ist ein Kontaktkolben 3 axial verschieblich gelagert. Der Kontaktkolben 3 weist dazu einen in der Führungshülse 2 axial verschiebbar gelagerten Kolbenschaft 4 sowie einen Kontaktkopf 5 auf. Der Kontaktkopf 5 ist dabei an einem von der Führungshülse 2 vorstehenden Ende des Kolbenschafts 4 angeordnet. Der Kontaktkopf kann einstückig mit dem Kolbenschaft 4 ausgebildet sein, oder ist, wie im Folgenden näher erläutert wird, als separates Bauteil an dem Kontaktstift 4 befestigt, insbesondere verschraubt. Der Kontaktkopf 5 weist einen Außendurchmesser auf, der größer ist als der Außendurchmesser des Kolbenschafts 4, insbesondere ist der Außendurchmesser des Kontaktkopfs 5 mindestens so groß wie der Außendurchmesser der Führungshülse 2. Zwischen dem Kontaktkopf 5 und der Führungshülse 2 ist ein Federelement 6 axial vorgespannt gehalten. Das Federelement 6 ist in dem vorliegenden Ausführungsbeispiel als Schraubenfeder ausgebildet, die koaxial zu dem Kolbenschaft 4 angeordnet ist und einendig an der der Führungshülse 2 zugewandten Rückseite des Kontaktkopfs 5 und anderendig an der dem Kontaktkopf 5 zugewandten Stirnseite der Führungshülse 2 anliegt. Der Kolbenschaft 4 weist darüber hinaus einen Axialanschlag auf, der mit der Führungshülse 2 derart zusammenwirkt, dass der Kontaktkolben 3 nicht aus der Führungshülse 2 durch das Federelement 6 herausgeschoben werden kann.

Figur 2 zeigt dazu in einer vereinfachten Längsschnittdarstellung die Kontakteinrichtung 1. Der Kolbenschaft 4 weist an seinem von dem Kontaktkopf 5 abgewandten Ende einen Radialvorsprung 7 auf, der den zuvor genannten Axialanschlag bildet. Der Radialvorsprung 7 weist dazu einen Außendurchmesser auf, der die Führungshülse 7 zumindest bereichsweise überragt, sodass er axial auf der Führungshülse im unbelasteten Zustand durch die Vorspannkraft des Federelements 6 aufliegt, wie in Figuren 1 und 2 gezeigt.

Der Kontaktkopf 5 ist gemäß dem vorliegenden Ausführungsbeispiel, wie insbesondere in Figur 2 ersichtlich, auf den Kolbenschaft 4 aufgeschraubt. Dazu weist der Schraubenschaft 4 an seinem von der Führungshülse 2 abgewandten Ende ein Außengewinde 8 auf, das mit einem Innengewinde 8 des Kontaktkopfs 5 zusammenwirkt.

Der Kontaktkopf 5 ist gemäß dem vorliegenden Ausführungsbeispiel einstückig ausgebildet und beispielsweise durch ein 3D-Metalldruckverfahren hergestellt.

Der Kontaktkopf 5 ist zumindest im Wesentlichen wannenförmig ausgebildet, wobei das Innengewinde 9 in einer Durchgangsöffnung 10 im Boden des Kontaktkopfs 5 ausgebildet ist. Von dem Boden steht eine sich über den gesamten Umfang des Kontaktkopfs 5 erstreckende Seitenwand vor, wobei die Seitenwand zumindest an ihrer Innenseite schräg beziehungsweise geneigt zur axialen Längserstreckung des Kontaktkolbens 3 und damit auch schräg zu dem quer zur Längserstreckung des Kontaktkolbens 3 ausgerichteten Bodens ausgerichtet ist. Dadurch bildet die Seitenwand 11 zusammen mit dem Boden eine wannenförmige Aufnahme 12, welcher mehrere Kontaktelemente 13 zugeordnet sind. Gemäß dem vorliegenden Ausführungsbeispiel sind die Kontaktelemente 13 kreissegmentförmig ausgebildet, sodass sie jeweils eine kreissegmentförmige Kontaktfläche aufweisen, die im unbelasteten Zustand, wie in Figuren 1 und 2 gezeigt, in einer gemeinsamen Ebene senkrecht zur Längserstreckung des Kolbenschafts und auf der von dem Kolbenschaft 4 abgewandten Seite des Kontaktkopfs 5 liegen. Die Kontaktflächen 14 bilden zusammen eine Kontaktoberfläche 15 des Kontaktkopfs 5, die gemäß dem vorliegenden Ausführungsbeispiel kreisringförmig ausgebildet ist. Die Kontaktelemente 13 enden an ihren einander zugewandten Enden beabstandet zueinander, sodass im Zentrum des Kontaktkopfs 5 beziehungsweise der Kontaktoberfläche 15 eine Durchgangsöffnung 16 verbleibt.

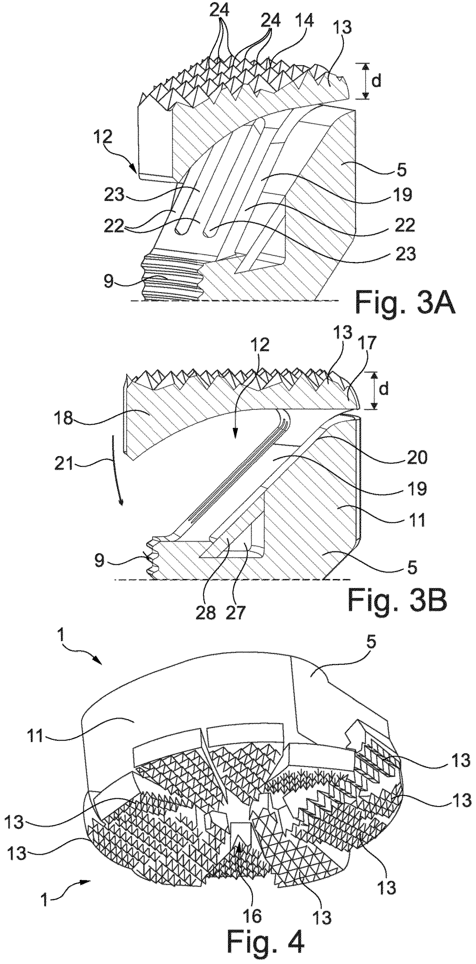

Figuren 3A und 3B zeigen jeweils in einer Detail-Schnittdarstellung eines der Kontaktelemente 13 in zwei unterschiedlichen Ansichten, zur Erläuterung der Anordnung der Kontaktelemente an dem Kontaktkopf 5. Wie bereits erwähnt, sind die Kontaktelemente 13 kreissegmentförmig ausgebildet. In der in Figuren 3A und 3B gezeigten Seitenansicht ist außerdem zu erkennen, dass die Kontaktelemente im Wesentlichen plattenförmig ausgebildet sind, wobei gemäß dem vorliegenden Ausführungsbeispiel eine Dicke d der Kontaktelemente 13 von ihrem jeweiligen Außenrand 17 bis zu dem dem Zentrum zugeordneten Innenrand 18 zunimmt, sodass die Kontaktelemente 13 jeweils keilförmig ausgebildet sind, und mit einer nach innen zunehmenden Stärke.

An dem Außenrand 17 des jeweiligen Kontaktelements 13 ist jeweils ein Federelement 19 befestigt. Die Federelemente 19 sind gemäß dem vorliegenden Ausführungsbeispiel als geradlinig verlaufende Federstreifen ausgebildet, die einendig an dem Außenrand des jeweiligen Kontaktelements 13 und anderendig an dem Boden des Kontaktkopfs 5 befestigt sind. Insbesondere sind die Federelemente 19 einstückig sowohl mit dem Kontaktelement 13 als auch mit dem Boden des Kontaktkopfs 5 ausgebildet. Hierzu bietet sich, wie bereits erwähnt, ein 3D-Druckverfahren an.

Die Federelemente 19 und die schräg verlaufende Innenseite der Seitenwand 11 verlaufen parallel zueinander, wie beispielsweise in Figur 3B ersichtlich. Dabei liegt das jeweilige Federelement 19 beabstandet zu der Innenseite der Seitenwand 11, sodass ein Freiraum zwischen diesen verbleibt. Die Innenseite der Seitenwand 11 dient nunmehr als Stützelement 20 für das jeweilige Federelement 19. Das Stützelement 20 beschränkt den Bewegungsweg des Federelements 19 in Richtung des Kontaktkopfs 5 beziehungsweise in Richtung des Bodens des Kontaktkopfs 5. Desto kleiner der Abstand zwischen dem Federelement 19 und dem Stützelement 20 im unbelasteten Zustand ist, desto kleiner ist auch die axiale Einfedertiefe des Kontaktelements 13 insgesamt. Das innenliegende freie Ende des jeweiligen Kontaktelements 13, also der Innenrand 18, ist jedoch weiter nach innen verlagerbar als der Außenrand, wie durch einen Pfeil 21 in Figur 3B angezeigt. Das jeweilige Kontaktelement 13 kann somit am Innenrand 18 axial weiter einfeden als am Außenrand, wodurch sich auch eine Schiefstellung des jeweiligen Kontaktelements 13 im belasteten Zustand ergeben kann.

Die Federelemente 19 sind optional, wie in Figuren 3A und 3B gezeigt, lamelliert ausgebildet. Dazu weisen sie in zumindest einem Längsabschnitt mehrere, vorliegend jeweils drei, beabstandet zueinander angeordnete Lamellen 22 auf, wobei jeweils zwei benachbarte Lamellen 22 durch einen dazwischenliegenden Längsschnitt 23 voneinander getrennt sind.

Wie in den vergrößerten Darstellungen der Figuren 3A und 3B außerdem gezeigt, ist die jeweilige Kontaktfläche 14 mit einer Kontaktspitzen 24 aufweisenden Oberflächenstruktur versehen. Gemäß dem vorliegenden Ausführungsbeispiel ist die Oberflächenstruktur als Pyramidenstruktur ausgebildet. Die Kontaktspitzen sorgen dafür, dass die zu kontaktierende Kontaktstelle eines Prüflings beim Verlagern des jeweiligen Kontaktelements 13 angekratzt wird, wodurch beispielsweise eine Korrosionsschutzschicht durchstoßen und der elektrische Kontakt zu der Kontaktstelle sicher hergestellt wird.

Figur 4 zeigt eine perspektivische Darstellung des Kontaktkopfs 5 im betätigten Zustand, wenn also der Kontaktkopf 5 mit den Kontaktelementen gegen eine Kontaktstelle eines Prüflings (hier nicht gezeigt) gedrückt wird. Die Kontaktelemente 13 federn unabhängig voneinander unterschiedlich weit in die Aufnahme 12 ein, je nachdem, wie die Kontaktstelle des Prüflings ausgebildet ist. Dadurch werden insbesondere Unebenheiten der Kontaktstelle sowie dreidimensional geformte Kontaktstellen sicher durch die Kontakteinrichtung 1 kontaktiert. In diesem Fall ist somit die Prüfeinrichtung 1 als einkanalige Prüfeinrichtung ausgebildet, da sie nur einen elektrischen Kontaktpfad aufweist.

Durch die vorteilhafte Ausbildung als Ringsegmente gewährleisten die Kontaktelemente 13, dass sie beim Einfedern nicht miteinander kollidieren und auch nicht aneinander verklemmen oder verkanten, sodass ein sicherer Betrieb der Kontakteinrichtung 1 jederzeit gewährleistet ist. Der Kontaktkopf 5 sowie der Kolbenschaft 4 sind bevorzugt aus einem elektrisch leitfähigen Material gefertigt, sodass eine elektrische Verbindung durch die Prüfeinrichtung 1 direkt durch die Kontaktelemente 13, und den Kontaktkolben 3 hindurch gewährleistet ist. Optional trägt der Kontaktkolben 3 ein weiteres, beispielsweise nadelförmiges Kontaktelement 25, wie in Figur 1 gezeigt, und/oder ein Sensorelement 26, die jeweils der Durchgangsöffnung 16 in der Kontaktoberfläche 15 zugeordnet sind, wobei das Kontaktelement 25 und/oder das Sensorelement 26 beispielsweise, wie in den Figuren 1 und 2 gezeigt, im unbelasteten Zustand der Kontakteinrichtung 1 von der Kontaktoberfläche 15 vorstehen können. Dadurch ist auch eine mehrkanalige Ausbildung der Prüfeinrichtung 1 erreichbar.

Die Kontakteinrichtung 1 ist darüber hinaus bevorzugt für Hochstromanwendungen ausgebildet. Dies ermöglicht zum einen, die große Kontaktoberfläche 15, die eine vorteilhafte elektrische Verbindung mit einer insgesamt großen Kontaktquerschnittsfläche gewährleistet. Darüber hinaus weist die Kontakteinrichtung 1 eine Kühleinrichtung 26 auf, durch welches insbesondere die Kontaktelemente 13 im Betrieb gekühlt werden können. Dadurch wird vermieden, dass der elektrische Widerstand der Kontakteinrichtung aufgrund einer zunehmenden Wärmeentwicklung im Betrieb zunimmt, und zum anderen, dass die mechanischen Eigenschaften der Prüfeinrichtung 1 im Betrieb nicht beeinträchtigt werden.

Die optionale Kühleinrichtung 26 weist dazu insbesondere einen dem Kontaktkopf 5 zugeordneten Kühlmittelkanal 27 auf. Gemäß dem vorliegenden Ausführungsbeispiel erstreckt sich der Kühlmittelkanal 27 durch die Seitenwand 11 zumindest im Wesentlichen über den gesamten Umfang des Kontaktkopfs 5. Dabei kann der Kühlmittelkanal 27 direkt integral in dem Kontaktkopf 5 ausgebildet sein, oder durch eine von einer Abdeckung 28 verschlossenen Vertiefung an der Innenseite der Seitenwand 11, wie in Figuren 3A und 3B beispielhaft gezeigt.

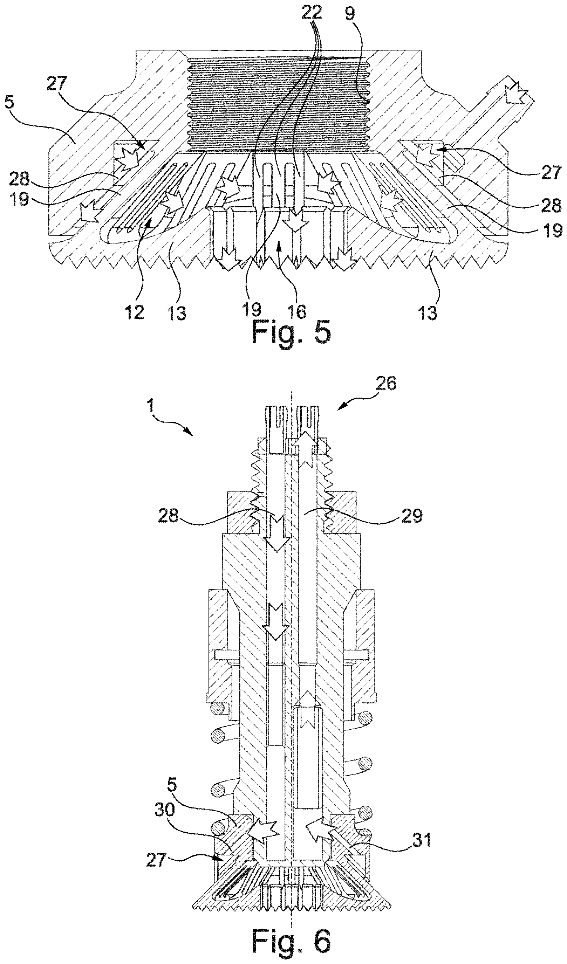

Vorteilhafterweise ist der den Federelementen 19 zugeordnete Wandabschnitt des Kühlmittelkanals 27, der auch als separate Abdeckung 28 ausgebildet sein kann, aus einem porösen beziehungsweise gasdurchlässigen Werkstoff gefertigt. Wird der Kühlmittelkanal 27 mit einem gasförmigen Kühlmittel beaufschlagt, so kann dieses durch die poröse Wandung hindurch zu den Federelementen 19 und damit zu den Kontaktelementen 13 strömen, wie mit Pfeilen in vergrößerten Längsschnittdarstellungen des Kontaktkopfs 5 in Figur 5 gezeigt. Hierbei wirkt sich auch die lamellierte Ausbildung der Federelemente 19 vorteilhaft aus.

Alternativ weist der Kühlmittelkanal 27 eine oder mehrere Durchströmungsöffnungen auf, durch welche das gasförmige Kühlmedium in den Aufnahmeraum 12 des Kontaktkopfs 5 gelangen kann.

Wird anstelle einer Gas-Kühlung eine Fluid-Kühlung mit einem flüssigen Medium vorgesehen, so weist der Kontaktkolben 3 vorteilhafterweise einen Zulaufkanal 28 und einen Ablaufkanal 29 auf. Figur 6 zeigt dazu in einer vereinfachten Längsschnittdarstellung eine vorteilhafte Weiterbildung der Prüfeinrichtung 26. Durch den Zulaufkanal 28 wird das flüssige Kühlmedium durch eine in dem Kontaktkopf 5 ausgebildete Zugangsöffnung 30 in den Kühlmittelkanal 27 gefördert. Durch eine Auslassöffnung 31 des Kontaktkopfs 5, die mit dem Kühlmittekanal 27 einerseits und der Ablaufleitung 29 andererseits fluidtechnisch gekoppelt ist, wird das in dem Kontaktkopf 5 erwärmte flüssige Kühlmedium wieder zurückgeführt, beispielsweise zu einer Kühleinrichtung, welche das Kühlmedium für einen weiteren Durchlauf des Kontaktkopfs 5 vorbereitet beziehungsweise kühlt.

## Patentansprüche

1. Kontakteinrichtung (1) zur Berührungskontaktierung einer elektrischen Kontaktstelle eines Prüflings, mit einem Kontaktkolben (3), der einen Kolbenschaft (4) zur axial verschiebbaren Lagerung in einer Führungshülse (2) sowie an einem freien Ende des Kolbenschafts (4) einen dem Prüfling zuordenbaren Kontaktkopf (5) aufweist, und mit zumindest einem an und/oder in dem Kontaktkopf (5) bewegbar gelagerten Kontaktelement (13), wobei dem Kontaktelement (13) zumindest ein Federelement (19) zugeordnet ist, das durch das Kontaktelement (13) bei einer Belastung durch eine Berührungskontaktierung entgegen seiner Federkraft elastisch verformbar ist, wobei an dem Kontaktkopf (5) mehrere der Kontaktelemente (13), die jeweils eine Kontaktfläche (14) zur Berührungskontaktierung aufweisen, derart nebeneinander angeordnet sind, dass die Kontaktflächen (14) im unbelasteten Zustand eine zumindest im Wesentlichen durchgehende Kontaktoberfläche (15) des Kontaktkopfs (5) für die Kontaktstelle ausbilden, **dadurch gekennzeichnet, dass** das jeweilige jeweils einem Kontaktelement (13) zugeordnete Federelement (19) einendig an dem Kontaktelement (13) und anderendig an dem Kontaktkopf (5) befestigt ist und zumindest abschnittsweise schräg in Bezug auf eine Längserstreckung des Kontaktkolbens (3) ausgerichtet ist.

2. Kontakteinrichtung nach Anspruch 1, **dadurch gekennzeichnet, dass** zumindest einige der Kontaktelemente (13) zur Ausbildung einer ringförmigen Kontaktoberfläche (15) jeweils ein Ringsegmentfläche mit ihrer Kontaktfläche (14) ausbilden, und dass die Kontaktflächen (14) insbesondere Kreissegmentflächen der Kontaktoberfläche (15) bilden.

3. Kontakteinrichtung nach einem der vorhergehenden Ansprüche, **dadurch gekennzeichnet, dass** die Kontaktoberfläche (15) eine kreisförmige, ovale oder mehreckige Außenkontur aufweist.

4. Kontakteinrichtung nach einem der vorhergehenden Ansprüche, **dadurch gekennzeichnet, dass** jedes Kontaktelement (13) nur durch das jeweils zugeordnete Federelement (6) an dem Kontaktkopf (5) gehalten ist.

5. Kontakteinrichtung nach einem der vorhergehenden Ansprüche, **dadurch gekennzeichnet, dass** das jeweilige Kontaktelement (13) als Ringsegment in einer Ebene quer, insbesondere senkrecht, zur Längserstreckung des Kontaktkolbens (3) ausgerichtet ist.

6. Kontakteinrichtung nach einem der vorhergehenden Ansprüche, **dadurch gekennzeichnet, dass** das Federelement (19) als geradlinig verlaufender Federstreifen ausgebildet ist, einen gekrümmten Verlauf von dem Kontaktkopf (5) zu dem Kontaktelement (13) aufweist, oder S-förmig verlaufend ausgebildet ist.

7. Kontakteinrichtung nach einem der vorhergehenden Ansprüche, **dadurch gekennzeichnet, dass** das Federelement (19) an einem Außenrand (17) des Kontaktelements (13) mit dem Kontaktelement (13) verbunden ist und sich von dem Außenrand (17) des Kontaktelements (13) in Richtung des Innenrands (18) des Kontaktelements (13) erstreckt.

8. Kontakteinrichtung nach einem der vorhergehenden Ansprüche, **dadurch gekennzeichnet, dass** das Federelement (19) einstückig mit dem Kontaktelement (13) und/oder mit dem Kontaktkopf (5) ausgebildet ist.

9. Kontakteinrichtung nach einem der vorhergehenden Ansprüche, **dadurch gekennzeichnet, dass** die freien, nach innen weisenden Enden der Kontaktelemente (13) zur Ausbildung einer Durchgangsöffnung (16) beabstandet zueinander enden.

10. Kontakteinrichtung nach einem der vorhergehenden Ansprüche, **dadurch gekennzeichnet, dass** das jeweilige Federelement (19) zumindest abschnittsweise in seiner Längserstreckung lamelliert ausgebildet ist.

11. Kontakteinrichtung nach einem der vorhergehenden Ansprüche, **dadurch gekennzeichnet, dass** der Kontaktkopf (5) zumindest ein parallel und beabstandet zu dem jeweiligen Federelement (19) verlaufendes Stützelement (20) zur Begrenzung eines Bewegungswegs des zugehörigen Kontaktelement (13) aufweist.

12. Kontakteinrichtung nach einem der vorhergehenden Ansprüche, **dadurch gekennzeichnet, dass** der Kontaktkopf (5) eine wannenförmige Aufnahme (12) aufweist, in welcher die Kontaktelemente (13) angeordnet sind.

13. Kontakteinrichtung nach einem der vorhergehenden Ansprüche, **dadurch gekennzeichnet, dass** die Kontaktflächen (14) der Kontaktelemente (13) eine Kontaktspitzen (24) aufweisende Oberflächenstruktur, insbesondere eine Pyramidenstruktur, aufweisen.

14. Kontakteinrichtung nach Anspruch 11, **dadurch gekennzeichnet, dass** der Kontaktkopf (5) zumindest einen Kühlmittelkanal (27) aufweist, der insbesondere durch das zumindest eine Stützelement (20) geführt ist.

15. Kontakteinrichtung nach Anspruch 14, **dadurch gekennzeichnet, dass** der Kühlmittelkanal (27) für jedes Kontaktelement (13) zumindest eine dem jeweiligen Kontaktelement (13) zugeordneten Durchströmungsöffnung oder im Bereich von zumindest einem Kontaktelement (13) einen dem Kontaktelement (13) zugeordneten Wandabschnitt aus einem gasdurchlässigen Material aufweist.

## Claims

1. A contact device (1) for contacting an electrical contact point of a test object, comprising a contact plunger (3), which has a plunger shaft (4) for mounting in a guide sleeve (2) in an axially displaceable manner as well as a contact head (5) which is assignable to the test object and arranged on a free end of the plunger shaft (4), and comprising at least one contact element (13), which is movably mounted on and/or in the contact head (5), wherein at least one spring element (19), which is elastically deformable against its spring force by means of the contact element (13) under a load resulting from a contact, is assigned to the contact element (13), wherein several of the contact elements (13), which in each case have a contact area (14) for contacting, are arranged next to one another on the contact head (5) in such a way that the contact areas (14) form an at least essentially continuous contact surface (15) of the contact head (5) for the contact point in the unloaded state, **characterized in that** the respective spring element (19) assigned to a respective contact element (13) is fastened to the contact element (13) on one end and to the contact head (5) on the other end, and is formed so as to be at least sectionally aligned obliquely with respect to a longitudinal extension of the contact plunger (3).

2. The contact device according to claim 1, **characterized in that** at least some of the contact elements (13) for forming a ring-shaped contact surface (15) in each case form a ring segment surface with its contact area (14), and that the contact areas (14) in particular form circular segment surfaces of the contact surface (15).

3. The contact device according to any one of the preceding claims, **characterized in that** the contact surface (15) has a circular, oval, or polygonal outer contour.

4. The contact device according to any one of the preceding claims, **characterized in that** each contact element (13) is held on the contact head (5) only by means of the respective assigned spring element (6).

5. The contact device according to any one of the preceding claims, **characterized in that** the respective contact element (13) is aligned as ring segment in a plane transversely, in particular perpendicularly to the longitudinal extension of the contact plunger (3).

6. The contact device according to any one of the preceding claims, **characterized in that** the spring element (19) is formed as a spring strip, which runs in a straight line, has a curved course from the contact head (5) to the contact element (13), or is formed so as to run in an S-shaped manner.

7. The contact device according to any one of the preceding claims, **characterized in that** the spring element (19) is connected to the contact element (13) on an outer edge (17) of the contact element (13) and extends from the outer edge (17) of the contact element (13) in the direction of the inner edge (18) of the contact element (13).

8. The contact device according to any one of the preceding claims, **characterized in that** the spring element (19) is formed in one piece with the contact element (13) and/or with the contact head (5).

9. The contact device according to any one of the preceding claims, **characterized in that** the free ends of the contact elements (13) pointing to the inside end spaced apart from one another in order to form a passage opening (16).

10. The contact device according to any one of the preceding claims, **characterized in that** the respective spring element (19) is formed in a lamellar manner at least section by section in its longitudinal extension.

11. The contact device according to any one of the preceding claims, **characterized in that** the contact head (5) has at least one support element (20), which runs parallel to and spaced apart from the respective spring element (19), for limiting a movement path of the corresponding contact element (13).

12. The contact device according to any one of the preceding claims, **characterized in that** the contact head (5) has a trough-shaped receptacle (12), in which the contact elements (13) are arranged.

13. The contact device according to any one of the preceding claims, **characterized in that** the contact areas (14) of the contact elements (13) have a surface structure, in particular a pyramid structure, having contact tips (24).

14. The contact device according to claim 11, **characterized in that** the contact head (5) has at least one coolant duct (27), which is in particular guided through the at least one support element (10).

15. The contact device according to claim 14, **characterized in that** the coolant duct (27) has for each contact element (13) at least one through-flow opening, which is assigned to the respective contact element (13), or, in the region of at least one contact element (13), a wall section made of a gas-permeable material assigned to the contact element (13).

## Revendications

1. Dispositif de contact (1) pour la mise en contact par effleurement d'un point de contact électrique d'un échantillon d'essai, avec un piston de contact (3) qui présente une tige de piston (4) pour le logement axialement mobile dans une douille de guidage (2) ainsi qu'une tête de contact (5) pouvant être associée à l'échantillon d'essai à une extrémité libre de la tige de piston (4), et avec au moins un élément de contact (13) logé de manière mobile sur et/ou dans la tête de contact (5), au moins un élément à ressort (19) étant associé à l'élément de contact (13), qui peut être déformé élastiquement par l'élément de contact (13) lors d'une charge par un contact par effleurement à l'encontre de sa force élastique, plusieurs des éléments de contact (13), qui présentent chacun une surface de contact (14) pour le contact par effleurement, sont disposés les uns à côté des autres sur la tête de contact (5) de sorte que les surfaces de contact (14) forment, à l'état sans charge, une surface de contact (15) au moins sensiblement continue de la tête de contact (5) pour le point de contact, **caractérisé en ce que** l'élément à ressort (19) respectif associé à un élément de contact (13) est fixé à une extrémité à l'élément de contact (13) et à l'autre extrémité à la tête de contact (5) et est orienté au moins par sections en biais par rapport à une extension longitudinale du piston de contact (3).

2. Dispositif de contact selon la revendication 1, **caractérisé en ce que** au moins quelques-uns des éléments de contact (13) forment, pour la formation d'une surface de contact annulaire (15), respectivement une surface de segment annulaire avec leur surface de contact (14), et **en ce que** les surfaces de contact (14) forment en particulier des surfaces de segment circulaire de la surface de contact (15).

3. Dispositif de contact selon l'une des revendications précédentes, **caractérisé en ce que** la surface de contact (15) présente un contour extérieur circulaire, ovale ou polygonal.

4. Dispositif de contact selon l'une des revendications précédentes, **caractérisé en ce que** chaque élément de contact (13) est maintenu sur la tête de contact (5) uniquement par l'élément à ressort (6) qui lui est respectivement associé.

5. Dispositif de contact selon l'une des revendications précédentes, **caractérisé en ce que** l'élément de contact (13) respectif est orienté comme un segment annulaire dans un plan transversal, en particulier perpendiculaire, à l'extension longitudinale du piston de contact (3).

6. Dispositif de contact selon l'une des revendications précédentes, **caractérisé en ce que** l'élément à ressort (19) est réalisé sous la forme d'une bande élastique rectiligne, présente un tracé incurvé de la tête de contact (5) à l'élément de contact (13), ou est réalisé en forme de S.

7. Dispositif de contact selon l'une des revendications précédentes, **caractérisé en ce que** l'élément à ressort (19) est relié à l'élément de contact (13) sur un bord extérieur (17) de l'élément de contact (13) et s'étend depuis le bord extérieur (17) de l'élément de contact (13) en direction du bord intérieur (18) de l'élément de contact (13).

8. Dispositif de contact selon l'une des revendications précédentes, **caractérisé en ce que** l'élément à ressort (19) est formé d'une seule pièce avec l'élément de contact (13) et/ou avec la tête de contact (5).

9. Dispositif de contact selon l'une des revendications précédentes, **caractérisé en ce que** les extrémités libres, orientées vers l'intérieur, des éléments de contact (13) se terminent à distance les unes des autres pour former une ouverture de passage (16).

10. Dispositif de contact selon l'une des revendications précédentes, **caractérisé en ce que** l'élément à ressort (19) respectif est réalisé de manière lamellaire au moins par sections dans son extension longitudinale.

11. Dispositif de contact selon l'une des revendications précédentes, **caractérisé en ce que** la tête de contact (5) présente au moins un élément de support (20) s'étendant parallèlement et à distance de l'élément à ressort (19) respectif pour limiter une course de déplacement de l'élément de contact (13) correspondant.

12. Dispositif de contact selon l'une des revendications précédentes, **caractérisé en ce que** la tête de contact (5) présente un logement (12) en forme de cuvette dans lequel sont disposés les éléments de contact (13).

13. Dispositif de contact selon l'une des revendications précédentes, **caractérisé en ce que** les surfaces de contact (14) des éléments de contact (13) présentent une structure de surface comportant des pointes de contact (24), en particulier une structure pyramidale.

14. Dispositif de contact selon la revendication 11, **caractérisé en ce que** la tête de contact (5) présente au moins un canal d'agent de refroidissement (27) qui est guidé en particulier par le au moins un élément de support (20).

15. Dispositif de contact selon la revendication 14, **caractérisé en ce que** le canal d'agent de refroidissement (27) présente pour chaque élément de contact (13) au moins une ouverture de passage associée à l'élément de contact (13) respectif ou, dans la zone d'au moins un élément de contact (13), une section de paroi associée à l'élément de contact (13) et constituée d'un matériau perméable au gaz.
